# EUROPÄISCHE PATENTANMELDUNG

(11) **EP 3 553 137 A1**
(43) Veröffentlichungstag der Anmeldung: **16.10.2019**
(21) Anmeldenummer: 18167217.1
(22) Anmeldetag: 13.04.2018
(51) Int. Cl.: C09C 1/36, C09C 3/06, A01N 59/16, A61L 2/232, C23C 16/455

(54) **PARTIKEL MIT EINER ANTIMIKROBIELLEN OBERFLÄCHE, WERKSTOFF ZUR HERSTELLUNG EINER BESCHICHTUNG MIT SOLCHEN PARTIKELN SOWIE HERSTELLUNGSVERFAHREN FÜR SOLCHE PARTIKEL**

(71) Anmelder: Siemens Aktiengesellschaft, 80333 München (DE)
(72) Erfinder: Doye, Christian, 13156 Berlin (DE); Jensen, Jens Dahl, 14050 Berlin (DE); Schneider, Manuela, 13581 Berlin (DE); Winkler, Gabriele, 13587 Berlin (DE)

(57) **Zusammenfassung**

Die Erfindung betrifft Partikel (11) mit einer antimikrobiellen Oberfläche. Erfindungsgemäß ist vorgesehen, dass diese Partikel mit einer Schicht ausgestattet sind, die sowohl Antimon-Zinnoxid (12), als auch Manganoxid (13) enthält. Diese Schicht wirkt vorteilhaft bei unterschiedlichen Bedingungen antimikrobiell, insbesondere sowohl bei einem nassen Milieu (aufgrund von elektrochemischen Vorgängen) als auch in trockenem Milieu (aufgrund von fotokatalytischen Eigenschaften). Dadurch ist eine zuverlässige Bekämpfung von Mikroorganismen mit diesen Partikeln möglich. Die Erfindung bezieht sich auch auf Werkstoffe, die zur Herstellung von Schichten oder Bauteilen geeignet sind, wie z. B. Kunststoffgranulaten. Diese weisen die oben genannten Partikel auf, damit diese in die Schicht oder das Bauteil eingebaut werden können. Zuletzt werden auch Herstellungsverfahren für die genannten Partikel beansprucht.

## Beschreibung

Die Erfindung betrifft Partikel mit einer antimikrobiellen Oberfläche. Weiterhin betrifft die Erfindung einen Werkstoff zur Herstellung einer Beschichtung, aufweisend einen Matrixwerkstoff und Partikel zur Einlagerung in einer aus diesem Matrixwerkstoff zu bildenden Matrix. Zuletzt betrifft die Erfindung Verfahren zur Erzeugung von Partikeln mit einer antimikrobiellen Oberfläche.

Bisher werden antimikrobiell wirkende Oberflächen aus sphärischen Partikeln gebildet. Dabei werden die antimikrobiell wirkenden Metalle, Metalloxide oder Metalloxidgemische häufig zu Nanoteilchen verarbeitet und dann Farben, Lacken oder Polymerwerkstoffen zugemischt. Diese antimikrobiell wirkenden Partikel können den UV-Anteil des Lichts nutzen, um keimabtötende Materialien zu bilden.

Andererseits werden antimikrobielle Oberflächen aufgrund des elektrochemischen Verhaltens von Metallen erzeugt, die bei Anwesenheit von Feuchtigkeit mikrogalvanische Zellen und durch die mikroelektrischen Felder keimabtötende Wirkung entfalten. Diese Metalle werden entweder galvanisch abgeschieden oder durch physikalisch-chemische Verfahren (PVD-, CVD-, Sputter- oder Sol-Gel-Verfahren) aufgebracht.

Daraus ergibt sich die Aufgabe, Partikel einer mit mikrobiellen Wirkung sowie Werkstoffe mit einer antimikrobiellen Wirkung anzugeben, mit denen unabhängig von den Umgebungsbedingungen eine gute mikrobielle Wirkung erzielt werden kann. Außerdem ist es Aufgabe der Erfindung, Verfahren zur Herstellung solcher antimikrobiellen Partikel anzugeben.

Diese Aufgabe wird mit den eingangs angegebenen Partikeln erfindungsgemäß dadurch gelöst, dass die Partikel mit einer Schicht ausgestattet sind, die sowohl Antimon-Zinnoxid als auch Manganoxid enthält. Es hat sich nämlich überraschenderweise gezeigt, dass eine solche Materialzusammensetzung der Schicht auf den Partikeln eine hervorragende antimikrobielle Wirkung aufweist. Zu diesem Zweck sind Untersuchungen durchgeführt worden, die folgende Ergebnisse erbracht haben.

Die Präzipitate wurden auf einen Glasträger gestrichen und die Materialöberflächen nach dem Standard ASTM E 2180-01 auf die antimikrobielle Wirksamkeit geprüft. Als Testorganismen wurden Gram-positive Bakterien, Staphylococcus aureus ATOC 6538, und Gram-negative Bakterien, Escherichia coli ATOC 8739, verwendet. Bereits nach dem Antrocknen der Zellen auf den Oberflächen (0h) zeigt sich eine deutliche Reduzierung der Bakterien, was auf eine schnelle Inaktivierung der Keime und ausgeprägte biozide Wirksamkeit von MnO2/ATO auf Titandioxidnadeln in feuchtem Milieu zurückzuführen ist. Nach vier Stunden Inkubationsdauer wurden 99,99 % der Keime abgetötet, was darauf hinweist, dass auch im trockenen Milieu eine antimikrobielle Wirkung zu verzeichnen ist.

Für jedes Material sowie jeden Probennahmezeitpunkt wurden 3 Parallelansätze kontaminiert. Es wurde die folgende Kontrolle mitgeführt: 0,2 ml der Keimsuspension wurden in ein Schraubdeckelreagenzglas mit 10 ml TSB direkt übertragen und wie oben weiter aufgearbeitet; hiermit war eine Aussage über die Effizienz der Keimabschwemmung von den Testflächen möglich.#

Folgende Muster wurden untersucht:
1) Vergleichsmuster Sn02 auf Titandioxidnadeln; im Folgenden als Sn02 bezeichnet
2) Antimikrobielle Partikel Sn02/Mn02 auf Titandioxidnadeln; im Folgenden als SN02/Mn02 bezeichnet

Für jedes Material sowie jeden Probennahmezeitpunkt wurden 3 Parallelansätze kontaminiert. Es wurde die folgende Kontrolle mitgeführt: 0,2 ml der Keimsuspension wurden in ein Schraubdeckelreagenzglas mit 10 ml TSB direkt übertragen und wie oben weiter aufgearbeitet; hiermit war eine Aussage über die Effizienz der Keimabschwemmung von den Testflächen möglich. In Tabelle 1 sind für Escherichia coli die zu den unterschiedlichen Zeiten von den Oberflächen zurückgewonnenen KBE aufgeführt. Tabelle 2 zeigt die entsprechenden Ergebnisse für Staphylococcus aureus. Tabelle 3 zeigt die insgesamt auf die Oberflächen aufgegebenen Keimzahlen, Tabelle 4 die zu den unterschiedlichen Inkubationszeiten von den unterschiedlichen Materialoberflächen zurückgewonnenen Keime, bezogen auf die insgesamt auf die Flächen aufgegebenen Keimmengen.

**Tabelle 1: Bakterizide Wirkung unterschiedlicher Materialien auf Escherichia co/i; Angegeben sind die insgesamt zurückgewonnen Keime von den Materialoberflächen (Mittelwert aus den Parallelen); aufgetragene Keime: 2,54 x 106**

| Material | Inkubationsdauer | |
|---|---|---|
| | 0 h | 4 h |
| SnO₂ | 4,17 x 10⁴ | 1,90 x 10³ |
| SnO₂/MnO₂ | 5,05 x 10⁴ | < 1.00 x 10¹ |

**Tabelle 2: Bakterizide Wirkung unterschiedlicher Materialien auf Staphylococcus aureus; Angegeben sind die insgesamt zurückgewonnen Keime von den Materialoberflächen (Mittelwert aus den Parallelen); aufgetragene Keime: 9,52 x 106**

| Material | Inkubationsdauer | |
|---|---|---|
| | 0h | 4h |
| SnO₂ | 5,09 x 10⁵ | 2,20 x 10⁴ |
| SnO₂/MnO₂ | 5,44 x 10⁵ | < 1,00 x 10¹ |

**Tabelle 3: Auf die Materialoberflächen aufgegebenen Keimmenge**

| Testorganismus | Aufgegebene Zellzahl |
|---|---|
| *Escherichia coli* | 2,54 x 10⁶ |
| *Staphylococcus aureus* | 9,52 x 10⁶ |

**Tabelle 4: Prozentuale Keimrückgewinnungsraten von unterschied 1 ichen Materialoberflächen nach unterschiedlicher Inkubationsdauer bezogen auf die aufgetragenen Keime.**

| Material | *Escherichia coli* Inkubationsdauer | | *Staphylococcus aureus* Inkubationsdauer | |
|---|---|---|---|---|
| | 0 h | 4h | 0 h | 4h |
| SnO₂ | 1,64% | 0,07% | 5,35 % | 0,23 % |
| SnO₂/MnO₂ | 1,99 % | < 0,01 % | 5,71 % | < 0,01 % |

Gemäß einer vorteilhaften Ausgestaltung der Erfindung ist vorgesehen, dass die Partikel die Form von Flakes und/oder Plättchen und/oder Nadeln haben. Diese Partikelformen haben den großen Vorteil, dass ein großes Aspektverhältnis gewährleistet ist. Mit anderen Worten weisen diese Partikelformen im Verhältnis zur Masse eine vergleichsweise große Oberfläche auf, welche zur Beschichtung zur Verfügung steht. Vorteilhaft kann daher mit minimalem Materialeinsatz eine vergleichsweise hohe antimikrobielle Wirkung erzielt werden, da hierfür die Oberfläche der besagten Schicht von Bedeutung ist.

Gemäß einer anderen Ausgestaltung der Erfindung ist vorgesehen, dass die Schicht aus einer inneren Lage aus Antimon-Zinnoxid und einer porösen äußeren Lage aus Manganoxid besteht. Dies hat den Vorteil, dass von Herstellern bereits mit Antimon-Zinnoxid beschichtete Partikel als Halbzeuge für eine Beschichtung mit Manganoxid verwendet werden können. Das Schichtsystem ist aufgrund der Porosität dennoch dazu geeignet, die beschriebenen vorteilhaften antimikrobiellen Eigenschaften zu erzeugen, weil das Antimon-Zinnoxid durch die Porosität des Manganoxids wirksam ist.

Im Folgenden wird das Manganoxid auch als Braunstein bezeichnet. Die Bezeichnung "Braunstein" soll im Zusammenhang mit dieser Anmeldung als Mineralgruppe verstanden werden, die die möglichen Manganoxide umfasst. Das Antimon-Zinnoxid wird im Folgenden auch mit ATO abgekürzt (ATO steht für den englischen Ausdruck Antimon-Tin-Oxide).

Die oben angegebene Aufgabe wird auch gelöst durch einen Werkstoff zur Herstellung einer Beschichtung, aufweisend einen Matrixwerkstoff und Partikel zur Einlagerung in eine Matrix, die aus diesem Matrixwerkstoff auf unterschiedliche Weise gebildet werden kann. Erfindungsgemäß sind die Partikel in der oben beschriebenen Weise ausgeführt, d. h., dass diese eine Schicht mit sowohl Antimon-Zinnoxid als auch mit Manganoxid enthält. Dies hat den Vorteil, dass die aus diesem Werkstoff hergestellten Schichten ebenfalls antimikrobielle Eigenschaften aufweisen, da die in die Schicht eingebauten Partikel diese Eigenschaft zumindest an der Oberfläche des hergestellten Bauteils bzw. der Beschichtung erfüllen.

Gemäß einer vorteilhaften Ausgestaltung der Erfindung kann der Matrixwerkstoff aus einem Kunststoffgranulat bestehen. Die Kunststoffgranulate werden in der Technik dazu verwendet, um im großen Maßstab Kunststoffteile herzustellen. Hierzu werden die Kunststoffgranulate aufgeschmolzen und in geeigneten Maschinen zu den Kunststoffteilen verarbeitet (beispielsweise durch Spritzgießen). Dabei können die Partikel in die entstehende Matrix des Bauteils eingebaut werden. An der Oberfläche des Bauteils entstehen hierdurch vorteilhaft antimikrobielle Eigenschaften.

Besonders vorteilhaft ist es, wenn die Partikel, die sehr viel kleiner sind, als die Körner des Kunststoffgranulats, auf der Oberfläche des Kunststoffgranulats, also auf den Körnern des Kunststoffgranulats angelagert sind. Hierdurch kann vorteilhaft erreicht werden, dass sich die Partikel zuverlässig in das herzustellende Bauteil einbetten lassen. Auch lässt sich durch die Belegung der Oberfläche der Körner des Kunststoffgranulats vorteilhaft die zu erreichende Konzentration an Partikeln in dem herzustellenden Bauteil (oder einer herzustellenden Kunststoffbeschichtung) einstellen.

Gemäß einer anderen Ausgestaltung der Erfindung kann vorgesehen werden, dass der Matrixwerkstoff aus einem Lack besteht, in dem die Partikel dispergiert sind. Lacke werden vorteilhaft in großem Maßstab zur Beschichtung von Bauteilen eingesetzt, dabei entsteht eine Lackschicht dadurch, dass ein Lösungsmittel des Lacks verdunstet und ein Pigment des Lacks auf der Oberfläche fixiert wird. Teil dieses Pigments sind erfindungsgemäß die oben bereits beschriebenen Partikel mit antimikrobieller Wirkung, wobei diese Wirkung auch an der Oberfläche der Lackschicht genutzt werden kann.

Zuletzt ist es vorteilhaft auch möglich, dass der Matrixwerkstoff in einem Elektrolyt ionisiert vorliegt, wobei die Partikel in dem Elektrolyt dispergiert sind. Auf diese Weise lässt sich vorteilhaft auf elektrochemischem Wege eine Beschichtung auf einem Bauteil herstellen, wobei in diese Beschichtung die dispergierten Partikel eingebaut werden. Während der elektrolytischen Beschichtung wird der Matrixwerkstoff aus dem Elektrolyt auf dem zu beschichtenden Bauteil abgeschieden. Hierdurch lassen sich beispielsweise metallische Schichten hervorragend erzeugen, deren antimikrobielle Eigenschaften durch den Einbau der Partikel verbessert wird.

Alle Werkstoffe, die oben genauer beschrieben wurden, eignen sich zudem vorteilhaft dazu, Bauteile bzw. Schichten derart herzustellen, dass auch bei einem Verschleiß der Oberfläche die antimikrobiellen Eigenschaften erhalten bleiben. Dies lässt sich dadurch erklären, dass die Partikel in der gesamten Matrix des Bauteils oder der Beschichtung vorgesehen sind und deswegen ein Materialabtrag der Oberfläche immer wieder neue Partikel freilegt, deren antimikrobiellen Eigenschaften sich bei Freilegung entwickeln können.

Außerdem wird die Erfindung durch das eingangs angegebene Verfahren erfindungsgemäß dadurch gelöst, dass bereits mit Antimon-Zinnoxid beschichtete Partikel verwendet werden und diese mit einem sogenannten Synproportionierung-Präzipitationsverfahren nasschemisch mit Manganoxid beschichtet werden, wobei folgende Schritte in der angegebenen Reihenfolge durchlaufen werden:
Suspendieren der Partikel in Wasser,
Zuführen der so erhaltenen Partikelsuspension zu einer Mangan(II)-Nitratlösung,
Einstellen eines pH-Werts von 8 durch Zuführen von Ammoniak, tröpfchenweises Zugeben von Kaliumpermanganlösung unter ständigem Rühren (bis zu 4 Stunden lang),
Abfiltrieren der beschichteten Partikel.
Hierdurch wird vorteilhaft ein wirtschaftliches Verfahren zur Herstellung der oben bereits genauer erläuterten Partikel angegeben.

Eine alternative Lösung der Aufgabe der Erfindung durch ein anderes Verfahren wird dadurch erreicht, dass mit Antimon-Zinnoxid beschichtete Partikel verwendet werden und diese mit einem Verfahren zur Atomlagenabscheidung (auch als ALD bezeichnet, was für "Atomic Layer Deposition" steht) mit Manganoxid beschichtet werden. Hierbei werden folgende Schritte in der angegebenen Reihenfolge durchlaufen:
Abscheiden von Manganprecursoren als ersten Reaktanden,
Einbringen von Wasserdampf als zweiten Reaktanden, und
Oxidieren des Manganprecursors in Anwesenheit von Sauerstoff. Gemäß einer vorteilhaften Ausgestaltung der Erfindung kann dieses Verfahren mit einem Wirbelstromreaktor durchgeführt werden.

Die Anwendung des ALD-Verfahrens hat den Vorteil, dass hierbei sehr dünne Schichten in hoher Präzision abgeschieden werden können. Hierdurch lassen sich die katalytischen Eigenschaften der antimikrobiellen Schicht vorteilhaft mit einem minimalen Materialaufwand erzeugen.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Es zeigen:
- Figur 1: verschiedene Standardpotentiale von Mangan,
- Figur 2: verschiedene Standardpotentiale von Antimon,
- Figur 3: ein Ausführungsbeispiel eines erfindungsgemäßen Partikels, als Titanoxidnadel ausgeführt, wobei diese mit ATO und porösem Braunstein beschichtet ist,
- Figur 4 und 5: verschiedene Ausgangsstoffe zur Herstellung eines Ausführungsbeispiels der erfindungsgemäßen Schicht durch ein ALD-Verfahren, dargestellt jeweils als Strukturformeln,
- Figur 6: ein Ausführungsbeispiel des erfindungsgemäßen Herstellungsverfahrens durch ALD-Abscheidung und
- Figur 7 und 8: einen Lack mit einem Ausführungsbeispiel der erfindungsgemäßen Partikel, die in diesem Lack dispergiert sind, im Vergleich zu einem Lack gemäß dem Stand der Technik mit runden Partikeln, jeweils im Schnitt dargestellt.

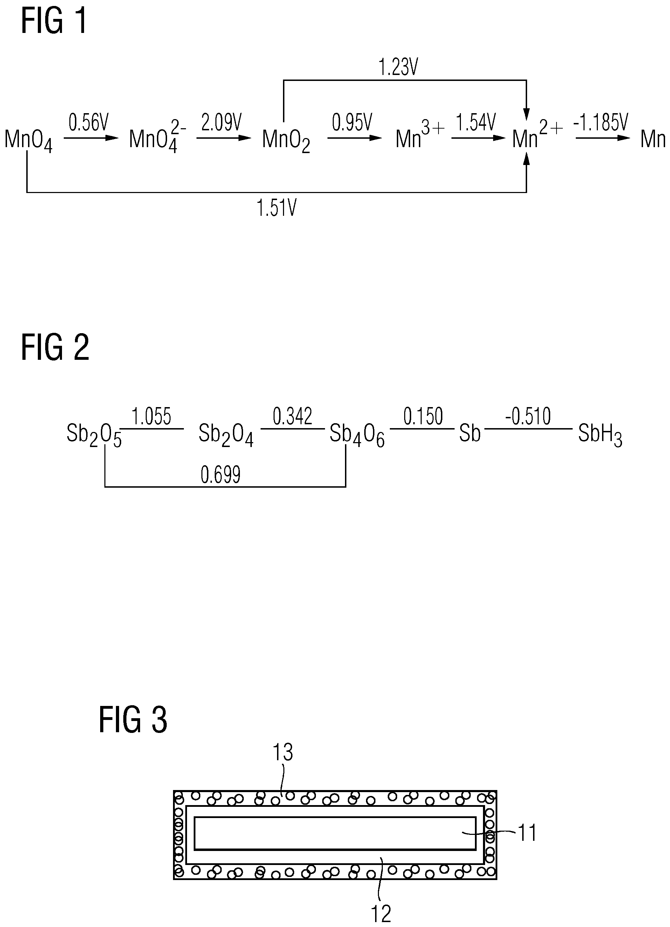

Eine antmikrobielle Schicht kann durch folgende Maßnahmen erzeugt werden. Auf einem Trägermaterial werden zwei Metalloxide als antimikrobiell wirkende Substanzen vorgesehen. Die Metalloxide werden aufgrund ihres elektrochemischen Verhaltens unter Berücksichtigung der Standardelektrodenpotentiale gemäß Figuren 1 und 2 (zusätzlich dem Standardelektrodenpotential von Zinn, s. u.) so ausgewählt, dass ein Metalloxid als Mikrokathode aus Braunstein, und das andere Metalloxid als Mikroanode aus Antimon- Zinnoxid (ATO) wirkt. Braunstein ist nach dem Standardpotential edler als Antimon- Zinnoxid. In Gegenward von Feuchtigkeit bildet sich zwischen den Metalloxiden ein elektrisches Feld aus. Damit können an den Metalloxiden Redoxprozesse ablaufen und durch stattfindende Elektronenübergänge Mikroben abgetötet werden.

Standardpotential von Zinn:

| | |
|---|---|
| Sn ⁴⁺ + 2e ⇄ Sn ²⁺ | 0,15 V |
| Sn ²⁺ + 2e ⇄ Sn | -0,14 V |

Als Trägermaterialien werden Partikel- Geometrien mit hohen Aspektverhältnissen gewählt, z.B. Nadeln, Flakes, Plättchen. Als Ausführungsbeispiel werden Titandioxid-Nadeln gewählt. Durch nass- oder physikalisch- chemische Verfahren (z.B. Atomlagenabscheidung) können auf Titandioxid- Nadeln antimikrobiell wirkende Oberflächen erzeugt werden. Titandioxid-Nadeln, die bereits mit einer Antimon-Zinnoxid- Schicht versehen sind, sind in unterschiedlichen Längen- und Breitenverhältnisse bei der Firma Ishihara erhältlich. Zur Beschichtung wurden im Ausführungsbeispiel Titandioxid- Nadeln mit Bezeichnung FT1000 verwendet, die 0,13 µm breit und 1,68 µm lang sind (siehe Figur 3).

Die Herstellung der erfindungsgemäßen Partikel gelingt beispielsweise durch einer nasschemische Herstellung von antimikrobiellen Oberflächen aus Metalloxiden auf Titandioxidnadeln. Auf den Titandioxid-Nadeln (Nadeln 11 in Figur 3) wird die antibakterielle Wirkung durch die Metalloxide Antimon-Zinnoxid (ATO) und Braunstein erzeugt. Da der Hersteller Titandioxid-Nadeln mit einer inneren Lage 12 aus ATO liefert, werden diese Nadeln über ein Synproportionierung-Präzipitations-Verfahren nasschemisch mit einer äußeren Lage 13 aus Mangandioxid abgeschieden.

Dazu werden Nadeln in Wasser suspendiert. Die TiO₂-Nadel-Suspension wird unter Rühren langsam einer Mangan(II)nitratLösung zugeführt. Befindet sich die gesamte Suspension in der Mangan(II)nitrat-Lösung, wird mit Ammoniak ein pH-Wert von 8 eingestellt. Anschließend wird zu der TiO₂-Mn(II)-NO₃-Mischung tropfenweise Kaliumpermanganat-Lösung zugegeben. Diese Mischung aus TiO₂-Nadeln, Mn(NO₃)₂, NH₃ und KMnO₄ wird mehrere Stunden gerührt. Die mit Braunstein beschichteten Titandioxidnadeln werden abfiltriert und gewaschen. Das Präzipitat wird 24 h in Anwesenheit von Luft über Nacht bei 110°C getrocknet. Danach erfolgt das Kalzinieren bei 425°C über mehrere Stunden.
Braunstein wird durch Synproportionierung der Komponenten Mangan(II)Nitrat und Permanganat auf dem ATO der Titandioxidnadeln durch Fällung nach Gleichung 1 abgeschieden.

3 Mn²⁺ + 2MnO₄ ⁻ + 2H₂O = 5MnO₂ + 4H⁺ Gleichung 1

Durch gleichzeitige Oxidation von Mn²⁺ und Reduktion von Mn⁷⁺ wird aus einer höheren und einer niedrigeren Oxidationsstufe zweier Mn-Atome eine dazwischenliegende Oxidationsstufe gebildet.

Die Herstellung der beschichteten Partikel gelingt alternativ auch durch eine physikalisch- chemische Abscheidung. Eine Alternative zur nass-chemischen Beschichtung stellt beipielsweise die Atomlagenabscheidung (ALD) dar. Hier werden die Nadeln aus der Gasphase über Manganprecursoren und Wasserdampf als zweiten Reaktanten mit Manganoxid beschichtet. Als Manganprecursoren können Bis(ethylcyclopentadienyl)-Mangan (II) oder Bis(N,N-di-isopropylpentylamidinato)Mangan(II) verwendet werden.

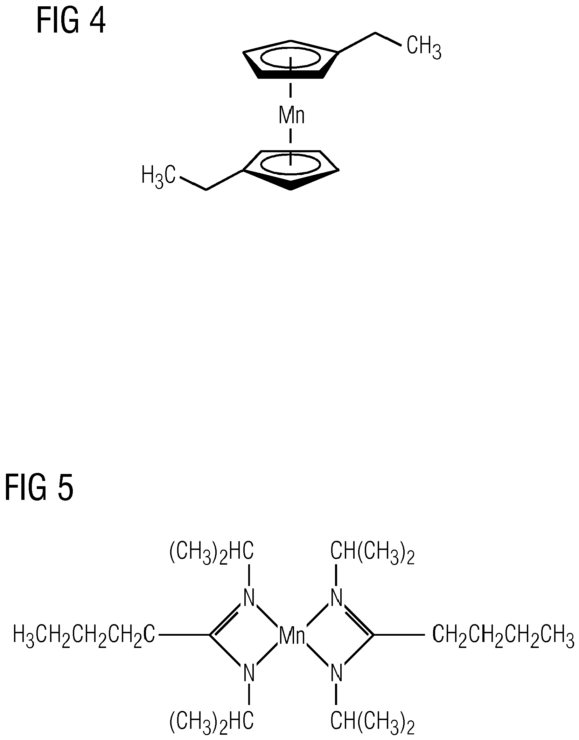

Figur 4 zeigt die Struktur von Bis(ethylcyclopentadienyl)-Mangen(II), Abkürzung Mn(CpEt)₂. Der Mangan-Dicyclopentadinyl-Komplex ist sehr reaktiv. Die Bindung zwischen dem Cyclopentadienyl-Anion (Cp) und dem Mangan ist sehr schwach.

Figur 5 zeigt die Struktur von Bis(N,N-di-isopropylpentylamidinato)Mangan(II). Mangan koordiniert mit den Amidinat-Liganden über die Stickstoffatome zu einer viergliedrigen Chelatringstruktur. Durch die komplexbildenen Effekte der Amidinat-Liganden ist das Mangan-Amidinat bei Raumtemperatur stabil, aber in Gegenward von Sauerstoff und Wasserdampf sehr reaktiv. Die Metall-Stickstoff-Bindungen und die C-N-Bindungen im Liganden sind geeignete Soll- Bruchstellen, weil die verzweigten Kohlenwasserstoff- Reste am N-Atom die Bindungselektronen stärker an sich ziehen als das Mangan-Atom und damit eine niedrigere Bindungsenergie gegenüber C-H- und C-C-Bindungen aufweisen. Die Fragmentierung des Mn-Amidinats erfolgt an der Mangan-Stickstoff-Bindung. In Gegenward von Wasserdampf zerfällt der Mn-Amidinat-Komplex in Manganoxid, in das volatile Acetamidin, in das Isopropanol und das n-Propanol.

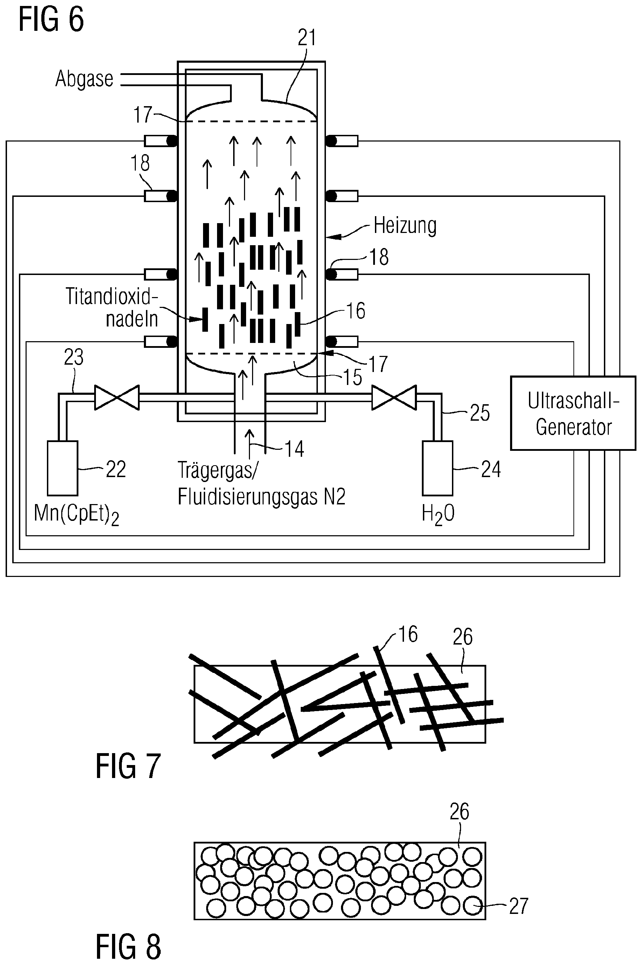

Prozessabfolge: Die Titandioxidnadeln mit ATO-Schicht werden in einem Wirbelstromreaktor (FBR, Fluidized Bed Reactor) gefüllt. Solch ein Wirbelstromreaktor ist in Figur 6 dargestellt. Das Gas 14, welches als Fluid agiert, tritt durch einen Verteiler 15, der am Boden einer Vakuumkammer 21 des Reaktors lokalisiert ist, in den Reaktor. Das Gas strömt aufwärts durch das Partikelbed und übt dabei eine nach oben gerichtete Kraft auf die Partikel 16 (Titanoxidnadeln) aus. Die Titandioxidnadeln würden sonst durch ihr Eigengewicht und die Gravitation nach unten gezogen werden. Der Gasstrom sollte so gewählt werden, dass die nach oben und nach unten wirkenden Kräfte ausbalanciert sind und ein fluidisierter Zustand entsteht. Damit die Titandioxidnadeln nicht aus dem Reaktor gesaugt oder geblasen werden, befindet sich unten und oben im FBR je Partikelfilter 17.

Zur Überwindung der Agglomerationskräfte zwischen den Nadeln sind unterstützende Methoden notwendig, damit sich ein fluidisierter Zustand einstellt. Eine Vibration des Wirbelstrombetts kann durch Ultraschallgeber 18, die an der Außenwand des FBR's angebracht sind, und über einen Ultraschallgenerator 19 gesteuert und geregelt werden.

Befinden sich die Titandioxidnadeln im Reaktor, wird über eine Pumpe ein Feinvakuum von 10⁻³ mbar im Reaktor eingestellt. Das bedeutet, dass die Luft abgepumpt wird. Danach werden die Nadeln Zustand durch Inertgaseinführung in einen fluidisierten überführt. In dem fluidisierten Zustand wird der Reaktorraum über Wärmestrahlung auf 140 bis 230°C erwärmt. Dazu befindet sich außerhalb des Reaktors eine Heizmanschette 20.

Mn(CpEt)₂ wird einerseits in einem Bubbler 22 als Schutz gegen Luftsauerstoff und Luftfeuchtigkeit aufbewahrt und andererseits über einen Thermostaten (nicht dargestellt) auf 80 bis 90°C erhitzt. Der Bubbler 22 ist mit einem Zuleitungsrohr und einem Entnahmerohr 23 ausgestattet. Über das Zuleitungsrohr gelangt Trägergas (Stickstoff) in den Bubbler und vermischt sich dort mit dem Mn(CpEt)₂-Dampf. Das Stickstoff-Precursordampf verlässt über das Entnahmerohr 23 den Bubbler und wird über das Entnahmerohr pneumatisch mit Hilfe von Ventilen in den FBR geleitet. Der Mn(CpEt)₂-Strom in dem FBR wird durch den Dampfdruck des Precursors und den geregelten Durchfluss des N₂-Trägergases so kontrolliert und gesteuert, dass eine Monolage Mn(CpEt)₂ auf die ATO-Oberfläche (nicht dargestellt, vgl. Figur 3) der Titandioxid-Nadeln chemisorbiert wird.

In einem zweiten Schritt werden überschüssige Mn(CpEt)₂- Gasmoleküle entfernt und der FBR mit Stickstoff gespült.

In einem dritten Schritt wird Wasserdampf als zweiter Reaktant aus einem Vorratsbehälter 24 über eine Leitung 25 in den FBR eingeleitet. Der Wasserdampf reagiert sofort mit dem Mn(CpEt)₂-Komplex unter Bildung von Manganoxid und dem volatilen Ethylcyclopentadien. Die Fragmentierung des Mn(CpEt)₂-Komplexes erfolgt zwischen dem Mangan-Atom und dem negativ geladenen, aromatischen Fünfringsystem.

In einem vierten Schritt werden das volatile Ethylcyclopentadien und der überschüssige Wasserdampf entfernt. Der Vakuumbehälter und die beschichteten Nadeln werden mit Stickstoff gespült.

Die beschriebenen Abscheidungsprozesse und die beiden Spül-/Evakuierungsprozesse zwischen den schichtbildenden Schritten umfassen einen Abscheidezyklus, der mehrmals wiederholt wird. Jeder Einzelprozess läuft vollständig ab. Das Mn(CpEt)₂ und der Wasserdampf werden sequentiell in die FBR-Kammer geleitet und auf der ATO-Oberfläche der Titandioxid-Nadeln solange chemisorbiert, bis die gesamte ATO-Oberfläche belegt ist. Danach finden keine weiteren Adsorptionsvorgänge statt. Die Einwirkdauer der einzelnen Schritte wird so gewählt dass in einer adäquaten Zeit die gerade eingeleitete Komponente mit der ATO-Oberfläche reagiert und der überschüssige Dampf, sowie die Nebenprodukte aus der Vakuumkammer 21 entfernt werden. Die Adsorptionszeit von Mn(CpEt)₂, die Spaltungszeit in MnO und Ethylcyclopentadien und Spülzeiten zwischen den Schicht- bildenden Vorgängen liegen in der Größenordnung von Sekunden. Durch diese Art der Prozessführung begrenzen sich die Oberflächenreaktionen selbst, so dass eine reproduzierbare Manganoxidschicht als äußere Lage 13 mit kalkulierbarer Zusammensetzung abgeschieden wird. Das abgeschiedene Manganoxid wächst mit jedem nachfolgenden Zyklus.

Die Anzahl der notwendigen Prozesszyklen, die Einwirkzeit der Beschichtungsreaktanten, sowie die Mengenbelegung an Bis(ethylcyclopentadienyl)- Mangen (II) und Wasserdampf pro Flächeneinheit und Zyklus richten sich nach der Größe (Breite u. Länge), Anzahl der Titandioxidnadeln und Schichtdicke des Mangandioxids.

Die Umsetzung (Gleichung 2) von Mn(cpEt)₂ mit Wasserdampf lautet:

Mn(CpEt)₂ + H₂O = MnO + 2HCpEt Gleichung 2

Anschließend werden die mit Mangan(II)oxid beschichteten Titandioxid-Nadeln bei 425°C in Gegenward von Luftsauerstoff mehrere Stunden kalziniert, um Braunstein zu erhalten.

Figur 7 und Figur 8 stellen verschiedene Ausführungsbeispiele von erfindungsgemäßen Bauteilen oder Schichten dar, die eine Matrix 26 beispielsweise aus Kunststoff aufweisen. In dieser Matrix sind gemäß Figur 7 Partikel 16 in Form von beschichteten Titanoxidnadeln untergebracht. Gemäß Figur 8 sind alternativ zu Titanoxidnadeln Flakes 27 verwendet. Es wird deutlich, dass sowohl die Flakes 27 als auch die Partikel 16 an der Oberfläche frei liegen und auf diese Weise ihre antimikrobiellen Eigenschaften entfalten können.

### Bezugszeichenliste

- 11: Nadeln
- 12: innere Lage (ATO)
- 13: äußere Lage (Braunstein)
- 14: Gas
- 15: Verteiler
- 16: Partikel
- 17: Partikelfilter
- 18: Ultraschallgeber
- 19: Ultraschallgenerator
- 20: Heizmanschette
- 21: Vakuumkammer
- 22: Bubbler
- 23: Entnahmerohr
- 24: Vorratsbehälter
- 25: Leitung
- 26: Matrix
- 27: Flakes

## Patentansprüche

1. Partikel mit einer antimikrobiellen Oberfläche
**dadurch gekennzeichnet,**
**dass** die Partikel mit einer Schicht (12, 13) ausgestattet sind, die sowohl Antimon-Zinnoxid als auch Manganoxid enthält.

2. Partikel nach Anspruch 1,
**dadurch gekennzeichnet,**
**dass** die Partikel die Form von Flakes und/oder Plättchen und/oder Nadeln (11) haben.

3. Partikel nach einem der voranstehenden Ansprüche,
**dadurch gekennzeichnet,**
**dass** die Schicht +11 aus einer inneren Lage (12) aus Antimon-Zinnoxid und einer porösen äußeren Lage (13) aus Manganoxid besteht.

4. Werkstoff zur Herstellung einer Beschichtung oder eines Bauteils, aufweisend einen Matrixwerkstoff und Partikel (16) zur Einlagerung in eine aus dem Matrixwerkstoff zu bildenden Matrix,
**dadurch gekennzeichnet,**
**dass** die Partikel (16) nach einem der voranstehenden Ansprüche aufgebaut sind.

5. Werkstoff nach Anspruch 5,
**dadurch gekennzeichnet,**
**dass** der Matrixwerkstoff aus einem Kunststoffgranulat besteht.

6. Werkstoff nach Anspruch 6,
**dadurch gekennzeichnet,**
**dass** die Partikel (16) auf der Oberfläche des Kunststoffgranulats angelagert sind.

7. Werkstoff nach Anspruch 5,
**dadurch gekennzeichnet,**
**dass** der Matrixwerkstoff aus einem Lack besteht, in dem die Partikel (16) dispergiert sind.

8. Werkstoff nach Anspruch 5,
**dadurch gekennzeichnet,**
**dass** der Matrixwerkstoff in einem Elektrolyt ionisiert vorliegt, wobei die Partikel (16) in dem Elektrolyt dispergiert sind.

9. Verfahren zum Erzeugen von Partikeln nach einem der Ansprüche 1 bis 3,
**dadurch gekennzeichnet,**
**dass** mit Antimon-Zinnoxid beschichtete Partikel verwendet werden und diese mit einem Synproportionierung-Präzipitationsverfahren nasschemisch mit Manganoxid beschichtet werden, wobei folgende Schritte in der angegebenen Reihenfolge durchlaufen werden:
• Suspendieren der Partikel (16) in Wasser
• Zuführen der so erhaltenen Partikelsuspension zu einer Mangan(II)nitratlösung,
• Einstellen eines pH-Wertes von 8 durch Zuführen von Anmmoniak,
• tröpfchenweises Zugeben von Kaliumpermanganatlösung unter ständigem Rühren,
• Abfiltrieren der beschichteten Partikel.

10. Verfahren zu Erzeugen von Partikeln nach einem der Ansprüche 1 bis 3,
**dadurch gekennzeichnet,**
**dass** mit Antimon-Zinnoxid beschichtete Partikel verwendet werden und diese mit einem Verfahren zur Atomlagenabscheidung (ALD) mit Manganoxid beschichtet werden, wobei folgende Schritte in der angegebenen Reihenfolge durchlaufen werden:
• Abscheiden von Manganprecursoren als ersten Reaktanden,
• Einbringen von Wasserdampf als zweiten Reaktanden,
• Oxidieren des Manganprecursors in Anwesenheit von Sauerstoff.

11. Verfahren nach Anspruch 10,
**dadurch gekennzeichnet,**
**dass** das Verfahren in einem Wirbelstromreaktor durchgeführt wird.
